# EUROPEAN PATENT APPLICATION

(11) **EP 1 587 153 A1**
(43) Date of publication of application: **19.10.2005**
(21) Application number: 05003184.8
(22) Date of filing: 15.02.2005
(51) Int. Cl.: H01L 51/10, H05B 33/04

(54) **Organic el device and method of manufacturing the same**

(30) Priority: 30.03.2004 JP 2004100450
(71) Applicant: KABUSHIKI KAISHA TOYOTA JIDOSHOKKI, Kariya-shi, Aichi-ken (JP)
(72) Inventor: Takeuchi, Kazuyoshi, Kariya-shi Aichi-ken (JP); Kidokoro, Atsushi, Kariya-shi Aichi-ken (JP); Tomida, Ryouichi, Kariya-shi Aichi-ken (JP); Kitamura, Kazunori, Kariya-shi Aichi-ken (JP)
(74) Representative: TBK-Patent

(57) **Abstract**

An EL device including an anode, an organic light emitting layer, and a cathode is formed on a glass substrate, and a sealing film made of Si and SiNₓ in which a ratio of the number of silicon atoms bonded to silicon atoms to the number of silicon atoms bonded to nitrogen atoms is equal to or larger than 0.6 but is equal to or smaller than 2.0 is formed on a surface of the EL element so as to cover the EL element.

## Description

### BACKGROUND OF THE INVENTION

### FIELD OF THE INVENTION:

The present invention relates in general to an organic electroluminescence (EL) device, and more particularly to an improvement in characteristics of a sealing film used in an organic EL device.

The present invention also relates to a method of manufacturing such an organic EL device.

### DESCRIPTION OF THE RELATED ART:

Heretofore, since an organic EL device can carry out self light emission to obtain a screen of high luminance, a practical application of the organic EL device is widely being advanced as a display device for a thin and light mobile apparatus or the like, or a lighting apparatus. This organic EL device has a structure in which an EL element including a pair of electrode layers at least one of which is a transparent electrode and an organic light emitting layer sandwiched between the pair of the electrode layers is formed on a substrate.

In such an organic EL device, there is such a fear that the organic light emitting layer and the electrode layers of the EL element may be damaged due to penetration of moisture and a gas such as oxygen to cause degradation of image quality and shortening of a life. Thus, it is proposed that the surface of the EL element is covered with a sealing film for the purpose of preventing moisture and a gas from penetrating from the outside.

For example, JP 2003-118030 A discloses an EL device in which a gas-barrier layer is formed on a surface of an organic base material by utilizing a dry method, a cured substance layer made of a cured substance of a composition containing polysilazane is formed on a surface of the gas-barrier layer by utilizing a wet method, and the resultant base material is disposed as a sealing film on a surface of an EL element.

However, as in the technique disclosed in JP 2003-118030 A, forming the gas-barrier layer and the cured substance layer on the surface of the organic base material and disposing the resultant base material on the surface of the EL element lead to a problem in that the EL device becomes complicated in structure to increase the thickness thereof, and the process for manufacturing the EL device also becomes complicated.

### SUMMARY OF THE INVENTION

The present invention has been made in order to solve the above-mentioned problems associated with the prior art, and it is, therefore, an object of the present invention to provide an organic EL device which is capable of, though its structure is simple, effectively preventing penetration of moisture and a gas.

It is another object of the present invention to provide a method of manufacturing an organic EL device which is capable of obtaining such an organic EL device.

An organic EL device according to the present invention includes: a substrate; an EL element which is formed on a surface of the substrate and which has at least a first electrode layer, an organic light emitting layer, and a second electrode layer; and a sealing film formed on a surface of the EL element so as to cover the EL element, the sealing film being made of Si and SiNₓ in which a ratio of the number of silicon atoms bonded to silicon atoms to the number of silicon atoms bonded to nitrogen atoms is equal to or larger than 0.6 but is equal to or smaller than 2.0.

The inventors of the present invention have earnestly repeated the research, and as a result, it has become clear that while even when a ratio of the number of silicon atoms bonded to silicon atoms to the number of silicon atoms bonded to nitrogen atoms is smaller than 0.6 or is larger than 2.0, water vapor permeability of the formed sealing film shows a unignorable value, when the ratio is equal to or larger than 0.6 but is equal to or smaller than 2.0, the water vapor permeability of the formed sealing film is equal to or smaller than a limit in measurement precision. As this cause, it can be judged that a suitable quantity of Si-Si bonding chains is dispersed into the Si-N bonding chains to enhance the sealing property.

Note that a second sealing film made of SiO₂ may be further formed on the surface of the sealing film by using polysilazane.

A method of manufacturing an organic EL device according to the present invention includes: forming on a substrate an EL element having at least a first electrode layer, an organic light emitting layer, and a second electrode layer; and supplying at least an SiH₄ gas and an N₂ gas and adjusting a flow rate of the SiH₄ gas and a supplied electric energy to form a sealing film made of Si and SiNₓ on a surface of the EL element so as to cover the EL element at a deposition rate of equal to or higher than 300 nm/minute but equal to or lower than 600 nm/minute by utilizing a plasma CVD method.

The deposition rate of the sealing film made of Si and SiNₓ largely depends on a flow rate of the SiH₄ gas and a quantity of supplied electric energy, and it becomes clear that when the deposition rate is equal to or higher than 300 nm/minute but is equal to or lower than 600 nm/minute, the water vapor permeability is equal to or smaller than a limit in measurement precision.

Note that it is preferable that the NH₃ gas is supplied at a ratio of a flow rate of an NH₃ gas to a flow rate of the SiH₄ gas be set as equal to or higher than 0.0, but be equal to or lower than 0.2 to form the sealing film by utilizing the plasma CVD method.

Also, a film made of SiO₂ may be formed by applying polysilazane to a surface of the sealing film, and subjecting it to a baking processing. Polysilazane may also be in a semidried state.

### BRIEF DESCRIPTION OF THE DRAWINGS

FIG. 1 is a cross sectional view showing a structure for an organic EL device according to Embodiment 1 of the present invention;
FIG. 2 is a graphical representation showing a relationship between a deposition rate of a sealing film and water vapor permeability thereof;
FIG. 3 is a graphical representation showing a relationship between a ratio of the number of silicon atoms bonded to silicon atoms to the number of silicon atoms bonded to nitrogen atoms in the sealing film and water vapor permeability thereof;
FIG. 4 is a graphical representation showing a relationship between a ratio of a flow rate of an NH₃ gas to a flow rate of an SiH₄ gas in manufacturing a sealing film and an amount of stress change of the manufactured sealing film;
FIG. 5 is a cross sectional view showing a structure for an organic EL device according to Embodiment 2 of the present invention; and
FIG. 6 is an enlarged cross sectional view showing a main portion of the organic EL device of Embodiment 2 when a foreign matter exists on a surface of an EL element.

### DESCRIPTION OF THE PREFERRED EMBODIMENTS

Preferred embodiments of the present invention will hereinafter be described in detail with reference to the accompanying drawings.

### Embodiment 1

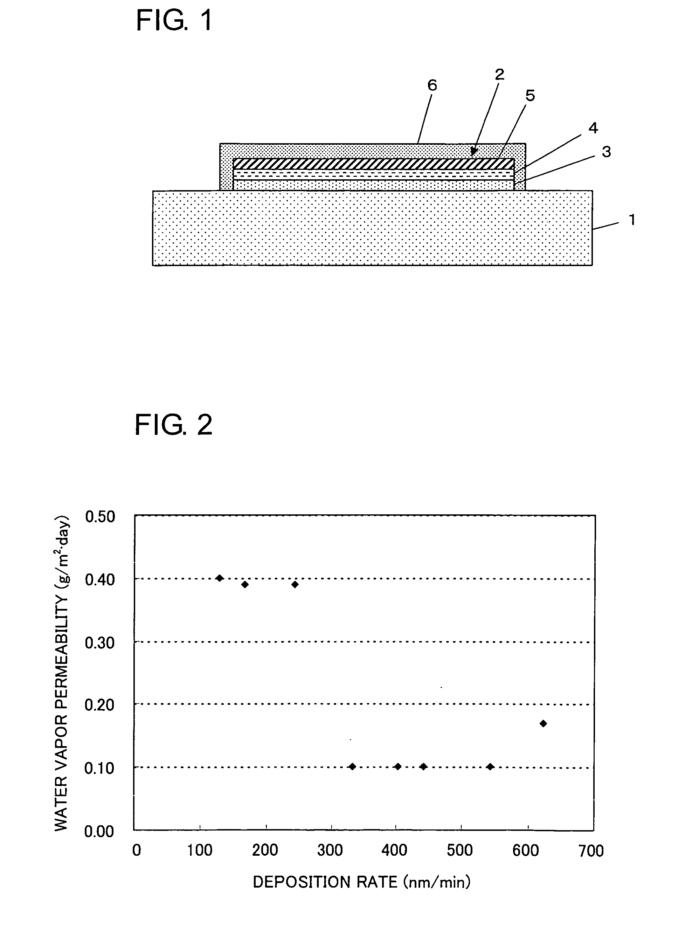

FIG. 1 is a cross sectional view showing a structure for an organic electroluminescence (EL) device according to Embodiment 1 of the present invention. An EL element 2 is formed on a transparent glass substrate 1. The EL element 2 includes an anode 3 as a first electrode layer formed on a surface of the glass substrate 1, an organic light emitting layer 4 formed on the anode 3, and a cathode 5 as a second electrode layer formed on the organic light emitting layer 4. A sealing film 6 is formed on a surface of the EL element 2 so as to cover the EL element 2.

The glass substrate 1 may be made of a transparent or semitransparent material which can transmit visible light. Thus, in addition to glass, a resin meeting such a condition may also be used as a material for the substrate. The anode 3 of the EL element 2 may have a function as an electrode, and may also be at least transparent or semitransparent so as to be able to transmit the visible light. Thus, for example, ITO may be adopted as a material for the anode 3. At least a known organic electroluminescence material such as Alq₃ or DCM is contained in a material for the organic light emitting layer 4. In addition, one or a plurality of layers, such as an electron transport layer and a hole transport layer, which are adopted in a known organic EL device, may also be suitably formed between the anode 3 and the cathode 5. Each layer is suitably made of a known material. The cathode 5 may have a function as an electrode and may have at least a reflection property for the visible light. Thus, for example, Al, Cr, Mo, an Al alloy, or Al/Mo lamination layer or the like may be adopted for the cathode 5. Each layer may be formed by utilizing a known thin film forming method such as a vapor deposition method.

The sealing film 6 is made of Si and SiNₓ. In this material, a ratio of the number of silicon atoms bonded to silicon atoms to the number of silicon atoms bonded to nitrogen atoms is equal to or larger than 0.6, but is equal to or smaller than 2.0. Using such a sealing film 6 makes it possible that the excellent sealing property is obtained and moisture and a gas is prevented from penetrating into the EL element 2 from the outside.

In this organic EL device, a main surface of the glass substrate 1 opposite to the surface having the EL element 2 formed thereon is a light emission surface. That is, light emitted from the organic light emitting layer 4 is directly made incident to the anode 3, or is indirectly made incident to the anode 3 after being reflected by the cathode 5 to be transmitted through the glass substrate 1 to be emitted from the light emission surface of the glass substrate 1 to the outside.

Next, a method of manufacturing the organic EL device according to Embodiment 1 of the present invention will hereinafter be described. First of all, the anode 3, the organic light emitting layer 4, and the cathode 5 are successively laminated on the surface of the glass substrate 1 by utilizing the known thin film forming method such as the vapor deposition method to form the EL element 2.

After that, the glass substrate 1 having the EL element 2 formed thereon is conveyed to a position within a chamber of a plasma CVD system in the vacuum or the inactive ambient atmosphere to form the sealing film 6 on the surface of the cathode 5 by utilizing the plasma CVD method. At this time, at least a SiH₄ gas and an N₂ gas are supplied into the chamber of the plasma CVD system. Then, the sealing film 6 is formed on the surface of the cathode 5 at a deposition rate of equal to or higher than 300 nm/minute but equal to or lower than 600 nm/minute which is obtained by adjusting a flow rate of the SiH₄ gas and a supplied electric energy.

As a result, the organic EL device is manufactured.

Here, a polycarbonate series film with a size of 100 mm x 100 mm x 0.4 mm was put into the chamber of the plasma CVD system and air within the chamber was then exhausted to a pressure of 1 x 10⁻³ Pa. Under this state, a SiH₄ gas, an NH₃ gas, and an N₂ gas were caused to flow into the chamber to adjust a pressure to 100 Pa. Then, a high frequency electric power of 13.56 MHz was applied between a pair of electrodes having a gap of 20 mm to discharge the gases, thereby depositing the sealing film having a thickness of 0.5 µm on the surface of the polycarbonate series film. At that time, when a flow rate of NH₃ and a flow rate of N₂ were adjusted to 50 ml/minute and 1,000 ml/minute, respectively, and the flow rate of SiH₄ and the electric energy applied between the pair of electrodes were adjusted to variously change the deposition rate of the sealing film, thereby forming the sealing films, respectively, and a ratio of the number of silicon atoms bonded to silicon atoms to the number of silicon atoms bonded to nitrogen atoms in each of the formed sealing films and water vapor permeability thereof were measured, the following measurement results as shown in TABLE 1 were obtained. Note that the water vapor permeability of 0.1 g/m²·day indicates that it is equal to or lower than a limit in measurement precision.

**TABLE 1**

| FLOW RATE OF SiH₄ (ml/min) | ELECTRIC ENERGY (W) | DEPOSITION RATE (nm/min) | RATIO OF NUMBER OF Si ATOMS BONDED TO Si ATOMS TO NUMBER OF Si ATOMS BONDED TO N ATOMS | WATER VAPOR PERMEABILITY (g/m²·day) |
|---|---|---|---|---|
| 75 | 500 | 128.0 | 0.381 | 0.4 |
| 100 | 600 | 167.1 | 0.401 | 0.39 |
| 200 | 700 | 242.8 | 0.484 | 0.39 |
| 200 | 800 | 332.4 | 0.742 | 0.1 |
| 300 | 700 | 403.3 | 1.169 | 0.1 |
| 300 | 800 | 441.9 | 1.375 | 0.1 |
| 500 | 800 | 543.3 | 1.717 | 0.1 |
| 500 | 1000 | 622.5 | 2.333 | 0.17 |

Note that the ratio of the number of silicon atoms bonded to silicon atoms to the number of silicon atoms bonded to nitrogen atoms in each of the formed sealing films was measured by analyzing each of the formed sealing films using an X-ray photoelectron spectroscope, i.e., AXIS ULTRA (manufactured by KRATOS Co., Ltd. of England). That is, X-rays were applied to the surface of the sealing film in high vacuum to measure the energies of the electrons emitted from the surface of the sealing film, thereby carrying out the qualitative and quantitative analysis for chemical elements. In this measurement, the X-ray photoelectron spectroscope was calibrated with an orbit 4f (84.00 eV) of Au having a bonding energy near that of an orbit 2p of Si in advance. The sealing film as a specimen was then introduced into the chamber and air within the chamber was exhausted to a pressure of equal to or lower than 1 x 10⁻⁷ Pa, and Ar ion etching for removal of an oxide film and contamination of the surface of the sealing film was carried out for 5 minutes. Then, a waveform of a bonding energy of 97 to 100 eV of the resultant specimen was obtained to be separated into a waveform (originating from silicon atoms bonded to nitrogen atoms) having a peak position at 101.9 eV, and a waveform (originating from silicon atoms bonded to silicon atoms) having a peak position at 99.7 eV. Then, an area ratio between the two waveforms was defined as a ratio of the number of silicon atoms bonded to silicon atoms to the number of silicon atoms bonded to nitrogen atoms.

In addition, the water vapor permeability was measured by utilizing a mocon method.

From the measurement results of TABLE 1, a relationship between the deposition rate and the water vapor permeability is obtained as shown in FIG. 2. It is understood from FIG. 2 that the water vapor permeability of the sealing film which is formed at the deposition rate of equal to or higher than 300 nm/minute but equal to or lower than 600 nm/minute is equal to or lower than a limit in measurement precision, and hence the sealing film manufactured under this condition shows the excellent sealing property.

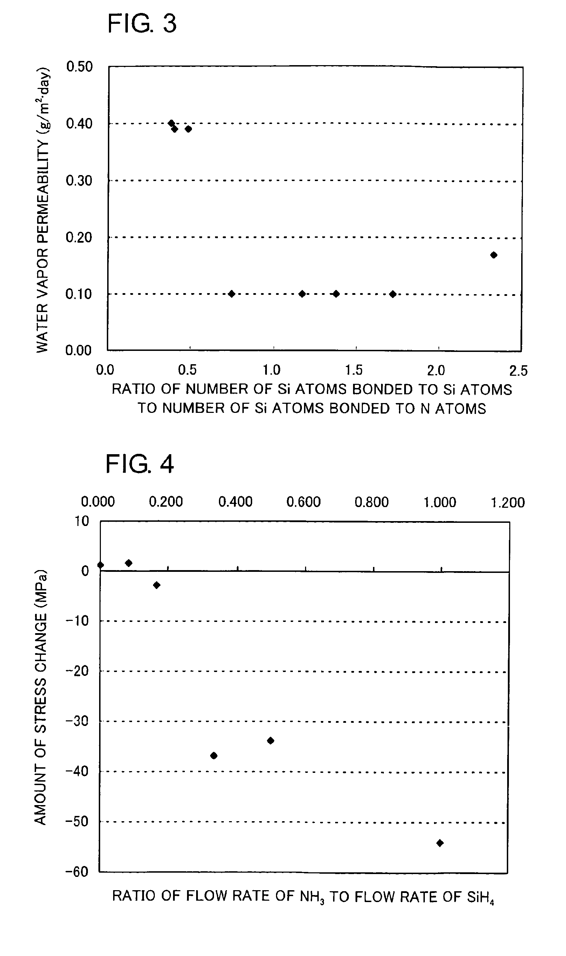

Likewise, from the measurement results of TABLE 1, a relationship between the ratio of the number of silicon atoms bonded to the silicon atoms to the number of silicon atoms bonded to nitrogen atoms and the water vapor permeability is obtained as shown in FIG. 3. It is understood from FIG. 3 that the water vapor permeability of the sealing film in which the ratio of the number of silicon atoms bonded to the silicon atoms to the number of silicon atoms bonded to nitrogen atoms is equal to or larger than 0.6, but is equal to or smaller than 2.0 is equal to or lower than a limit in measurement precision, and hence the sealing film manufactured under this condition shows the excellent sealing property.

In addition, the flow rate of the SiH₄ gas flowing into the chamber of the plasma CVD system was adjusted to 300 ml/minute, and the supplied electric energy applied between the electrodes was adjusted to 700 W to obtain the deposition rate of the sealing film of about 400 nm/minute, and under this condition, the flow rate of the NH₃ gas was variously changed to 0, 25, 50, 100, 150 and 300 ml/minute to form the sealing films each having a thickness of 2.0 µm, respectively. Note that the flow rate of N₂ was set to 1,000 ml/minute, and the frequency of the supplied electric energy was set to 13.56 MHz. When the initial stresses of the formed sealing films, and the stresses thereof after the formed sealing films were left for 500 hours in a high temperature and high humidity vessel (manufactured by TABAIESPEC Co., Ltd) which was held at a temperature of 60°C and at a relative humidity of 90% were measured, the measurement results as shown in TABLE 2 were obtained.

**TABLE 2**

| FLOW RATE OF SiH₄ (ml/min) | FLOW RATE OF NH₃ (ml/min) | RATIO OF FLOW RATE OF NH₃ TO FLOW RATE OF SiH₄ | INITIAL STRESS (MPa) | STRESS AFTER 500 HOURS (MPa) | AMOUNT OF STRESS CHANGE (MPa) |
|---|---|---|---|---|---|
| 300 | 0 | 0.000 | -50.94 | -49.76 | 1.18 |
| 300 | 25 | 0.083 | -73.49 | -71.90 | 1.59 |
| 300 | 50 | 0.167 | -70.52 | -73.34 | -2.82 |
| 300 | 100 | 0.333 | -65.05 | -101.92 | -36.87 |
| 300 | 150 | 0.500 | -77.20 | -111.06 | -33.86 |
| 300 | 300 | 1.000 | -62.38 | -116.39 | -54.01 |

Note that the sealing film was formed on a 4-inch Si wafer a quantity of warp of which was measured in advance, and then a quantity of warp of the Si wafer right after the formation of the sealing film and a quantity of warp of the Si wafer after the sealing film was left for 500 hours in the high temperature and high humidity vessel were measured again, and then the resultant quantities of warp of the Si wafers were compared with the quantity of warp of the Si wafer before the formation of the sealing film, respectively, thereby calculating the initial stress of the sealing film and the stress of the sealing film after the sealing film was left for 500 hours in the high temperature and high humidity vessel. Then, a difference between the initial stress of the sealing film and the stress of the sealing film after the sealing film was left for 500 hours is defined as an amount of stress change.

From the measurement results of TABLE 2, a relationship between the ratio of the flow rate of NH₃ to the flow rate of SiH₄ and the amount of stress change is obtained as shown in FIG. 4. It is understood from FIG. 4 that when the ratio of the flow rate of NH₃ to the flow rate of SiH₄ is equal to or larger than 0.0 but is equal to or smaller than 0.2, the amount of stress change is remarkably small. The organic light emitting layer and the electrode layers of the EL element which are obtained through the known deposition process by utilizing the vapor deposition method or the like are low in mechanical strength. Hence, in order to prevent the organic light emitting layer and the electrode layers of the EL element from being broken, a small long term change in stress is required for the sealing film which is formed so as to cover the EL element. Then, when the sealing film is formed under the condition in which the ratio of the flow rate of NH₃ to the flow rate of SiH₄ is equal to or larger than 0.0 but is equal to or smaller than 0.2, the sealing film which shows a small amount of stress change can be obtained, and thus it is possible to realize the organic EL device which is excellent in reliability.

### Embodiment 2

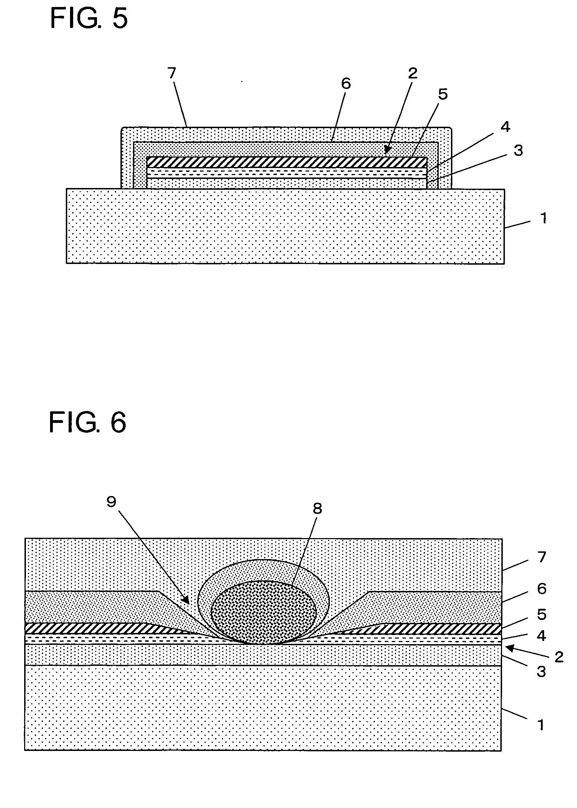

FIG. 5 shows a cross sectional view of an organic EL device according to Embodiment 2 of the present invention. This organic EL device is such that a second sealing film 7 is formed on the surface of the sealing film 6 in Embodiment 1 shown in FIG. 1.

An SiO₂ film having a thickness of 0.01 to 2.0 µm which is formed using polysilazane is used as the second sealing film 7. Here, it is supposed in this specification that polysilazane contains dielectric as well in which a part of hydrogen atoms bonded to silicon atoms is replaced with an alkyl group or the like. The second sealing film 7 contains an alkyl group, especially, a methyl group having a small molecular weight, whereby the adhesive property with the sealing film 6 as a base is improved and the SiO₂ film is given flexibility, and hence even when a thickness of the second sealing film 7 is increased, the generation of cracks is suppressed. As for the alkyl group, one having 1 to 4 carbon atoms is preferable. In addition, polysilazane may be one in a semidried state in which unreacted constituents are left therein.

A method of manufacturing the organic EL device according to Embodiment 2 of the present invention will hereinafter be described. As in the case of manufacturing the organic EL device according to Embodiment 1 of the present invention, the anode 3, the organic light emitting layer 4, and the cathode 5 are successively laminated on the surface of the glass substrate 1 by utilizing the known thin film forming method such as the vapor deposition method to form the EL element 2. After that, the glass substrate 1 having the EL element 2 formed thereon is conveyed to a position within a chamber of a plasma CVD system to form the sealing film 6 on the surface of the cathode 5 by supplying at least a SiH₄ gas and an N₂ gas into the chamber of the plasma CVD system and also at a deposition rate of equal to or higher than 300 nm/minute but equal to or lower than 600 nm/minute which is obtained by adjusting a flow rate of the SiH₄ gas and a supplied electric energy.

After that, the glass substrate 1 having the EL element 2 and the sealing film 6 formed thereon is exposed to the atmosphere to apply polysilazane onto the surface of the sealing film 6. As for the application method, it is possible to utilize the various kinds of methods such as a spin coating method, a dip method, a flow method, a roll coating method, and a screen printing method. In addition, polysilazane may also be applied onto the surface of the sealing film 6 in the ambient atmosphere when the sealing film 6 was formed, or in the inactive ambient atmosphere without being exposed to the atmosphere.

Following this, the glass substrate 1 having the EL element 2, the sealing film 6, and polysilazane formed thereon is subjected to the baking processing using a heating unit such as an oven or a hot plate so that the reaction in polysilazane proceeds in accordance with the following reaction formula to form the second sealing film 7 on the surface of the sealing film 6:

[-SiH₂NH-]ₙ + 2H₂O → SiO₂ + NH₃ + 2H₂

As a result, an organic EL device according to Embodiment 2 of the present invention is manufactured.

In a case where as shown in FIG. 6, a foreign matter 8 such as dust exists on the surface of the EL element 2, there is such a fear that even when the sealing film 6 is formed on the surface of the EL element 2, the foreign matter 8 can not be perfectly covered with the sealing film 6, and thus an unadhered portion 9 may be generated in the sealing film 6. However, in Embodiment 2, since polysilazane is applied onto the sealing film 6 to form the second sealing film 7, the resultant second sealing film 7 covers the unadhered portion 9 of the sealing film 6 as the base. Consequently, it is possible to prevent the moisture and a gas from penetrating into the EL element 2 from the outside.

In addition, since after the sealing film 6 is formed on the surface of the EL element 2, polysilazane is applied onto the surface of the sealing film 6 to form the second sealing film 7, it is possible to prevent the EL element 2 from being damaged.

In addition to dust, glass powder, attachments of a photo resist film or the like is conceivable as the foreign matter 8. In any case, however, the unadhered portion 9 can be covered with the second sealing film 7 to prevent the moisture and a gas from penetrating into the EL element 2.

When the unreacted constituent of the applied polisilazane in the process for the baking processing is left, the unreacted polysilazane reacts with the penetrated moisture, resulting in that the penetrated moisture is prevented from reaching the EL element 2. As a result, it is possible to prevent the degradation of the EL element 2 due to the penetrated moisture.

In Embodiments 1 and 2 of the present invention described above, the description has been given with respect to a bottom emission type organic EL device in which the transparent anode 3, the organic light emitting layer 4, and the reflective cathode 5 are successively laminated on the glass substrate 1, and thus the light emitted from the organic light emitting layer 4 is transmitted through the transparent anode 3 and the glass substrate 1 to be emitted to the outside. However, the present invention is not intended to be limited to the bottom emission type organic EL device. That is, the present invention is also applied to a top emission type organic EL device in which a reflective electrode, an organic light emitting layer, and a transparent electrode are successively laminated on a substrate, and thus light emitted from the organic light emitting layer is transmitted through the transparent electrode opposite to the substrate to be emitted to the outside. In this case, first and second sealing films are successively formed on the transparent electrode. Thus, each of the first and second sealing films must be made of a transparent or semitransparent material adapted to transmit the visible light.

According to the present invention, the sealing film made of Si and SiNₓ in which the ratio of the number of silicon atoms bonded to silicon atoms to the number of silicon atoms bonded to nitrogen atoms is equal to or larger than 0.6 but is equal to or smaller than 2.0 is formed on the surface of the EL element. Hence, though the EL device is simple in structure, it is possible to prevent the moisture and the gas from penetrating into the EL element.

### Example 1

An anode with 190 nm thickness made of ITO was formed on a transparent glass substrate by utilizing a reactive sputtering method. Then, as the cleaning for the substrate before the formation of a light emitting layer by the vapor deposition, the substrate was cleaned using an alkali solution, and was then cleaned using purified water, and after being dried, the substrate was cleaned using an ultraviolet light/ozone cleaning light source.

The substrate having the anode formed thereon was transferred to a vapor deposition system, and copper phthalocyanine was then deposited in a thickness of 10 nm on the surface of the anode to form a hole injection region at a deposition rate of 0.1 nm/second and at a degree of vacuum of about 5. 0 x 10⁻⁵ Pa using a carbon crucible.

Next, tetramer of a triphenylamine was deposited in a thickness of 30 nm on the surface of the hole injection region to form a hole transport region at a deposition rate of 0.1 nm/second and at a degree of vacuum of 5.0 x 10⁻⁵ PA using a carbon crucible.

Further, DPVBi (color of emitted light : blue) was deposited in a thickness of 30 nm on the surface of the hole transport region to form a light emitting region at a deposition rate of 0.1 nm/second and at a degree of vacuum of 5.0 x 10⁻⁵ PA.

Alq3 as a quinolinolato series metal complex was deposited in a thickness of 20 nm on the light emitting region to form an electron transport region at a deposition rate of 0.1 nm/second and at a degree of vacuum of about 5.0 x 10⁻⁵ Pa using a carbon crucible.

After that, LiF was deposited in a thickness of 0.5 nm on the electron transport region to form a cathode interface region at a deposition rate of 0.03 nm/second and at a degree of vacuum of 5.0 x 10⁻⁵ Pa using a carbon crucible. Moreover, aluminum was deposited in a thickness of 100 nm on the cathode interface region to form a cathode at a deposition rate of 1 nm/second and at a degree of vacuum of about 5.0 x 10⁻⁵ Pa using a tungsten board.

After the EL element was formed on the glass substrate in such a manner, a film made of Si and SiNₓ was formed as the sealing film on the surface of the EL element using a plasma CVD system. That is, the glass substrate was put into the chamber of the plasma CVD system, and air within the chamber was exhausted to a pressure of 1.0 x 10⁻³ Pa. Then, a SiN₄ gas, an NH₃ gas, and an N₂ gas, were caused to flow into the chamber at a flow rate of 300 ml/minute, at a flow rate of 50 ml/minute, and at a flow rate of 1,000 ml/minute, respectively, to adjust a pressure to 100 Pa. Next, a high frequency electric power of 13.56 MHz and 700 W was applied across a pair of electrodes having a gap of 20 mm to discharge the mixed gas, thereby depositing and forming the sealing film in a thickness of 1 µm on the surface of the EL element.

A ratio of the number of silicon atoms bonded to silicon atoms to the number of silicon atoms bonded to nitrogen atoms in the sealing film of the organic EL device thus manufactured was 1.169. Also, when the water vapor permeability of the sealing film was measured, the water vapor permeability was equal to or lower than a limit in measurement precision. The amount of stress change after the formed sealing film was left under the environment in which a temperature was 60°C and a relative humidity was 90% for 500 hours was such a small value as to be -2.82 MPa.

### Example 2

Similarly to Example 1, after an EL element was formed on a transparent glass substrate and a sealing film made of Si and SiNₓ was formed on the surface of the EL element using a plasma CVD system, 20 wt% polysilazane, i.e., NL-120 (manufactured by CLARIANT JAPAN Co., Ltd.) was applied onto the surface of the sealing film using a spinner having a rotating speed set as 500 rpm to be dried at 90°C for 30 minutes using a hot plate, thereby forming a second sealing film made of SiO₂ a thickness of 0.5 µm.

An EL device including an anode, an organic light emitting layer, and a cathode is formed on a glass substrate, and a sealing film made of Si and SiNₓ in which a ratio of the number of silicon atoms bonded to silicon atoms to the number of silicon atoms bonded to nitrogen atoms is equal to or larger than 0.6 but is equal to or smaller than 2.0 is formed on a surface of the EL element so as to cover the EL element.

## Claims

1. An organic EL device, comprising:
a substrate;
an EL element which is formed on a surface of the substrate and which has at least a first electrode layer, an organic light emitting layer, and a second electrode layer; and
a sealing film formed on a surface of the EL element so as to cover the EL element,
the sealing film being made of Si and SiNₓ in which a ratio of the number of silicon atoms bonded to silicon atoms to the number of silicon atoms bonded to nitrogen atoms is equal to or larger than 0.6 but is equal to or smaller than 2.0.

2. An organic EL device according to claim 1, further comprising a second sealing film formed on a surface of the sealing film.

3. An organic EL device according to claim 2, wherein the second sealing film is an SiO₂ film formed by using polysilazane.

4. An organic EL device according to claim 3, wherein the second sealing film has a thickness of 0.01 to 2.0 µm.

5. An organic EL device according to claim 1, wherein the organic EL device is of a bottom emission type.

6. An organic EL device according to claim 1, wherein the organic EL device is of a top emission type.

7. A method of manufacturing an organic EL device, comprising the steps of:
forming on a substrate an EL element having at least a first electrode layer, an organic light emitting layer, and a second electrode layer; and
supplying at least an SiH₄ gas and an N₂ gas and adjusting a flow rate of the SiH₄ gas and a supplied electric energy to form a sealing film made of Si and SiNₓ on a surface of the EL element so as to cover the EL element at a deposition rate of equal to or higher than 300 nm/minute but equal to or lower than 600 nm/minute by utilizing a plasma CVD method.

8. A method of manufacturing an organic EL device according to claim 7, wherein the NH₃ gas is supplied at a ratio of a flow rate of an NH₃ gas to a flow rate of the SiH₄ gas is set as equal to or higher than 0.0 but is equal to or lower than 0.2 to form the sealing film by utilizing the plasma CVD method.

9. A method of manufacturing an organic EL device according to claim 7, wherein polysilazane is applied to a surface of the sealing film, and is subjected to a baking processing to form a second sealing film made of SiO₂.

10. A method of manufacturing an organic EL device according to claim 9, wherein the polysilazane is applied by utilizing any one of a spin coating method, a dip method, a flow method, a roll coating method and a screen printing method.

11. A method of manufacturing an organic EL device according to claim 9, wherein the polysilazane is in a semidried state.
